# EUROPÄISCHE PATENTSCHRIFT

(11) **EP 3 740 973 B1**
(45) Veröffentlichungstag und Bekanntmachung des Hinweises auf die Patenterteilung: **10.11.2021**
(21) Anmeldenummer: 19712509.9
(22) Anmeldetag: 11.03.2019
(51) Int. Cl.: H01L 31/18, H01L 31/0687, H01L 33/00, H01L 33/30, H01L 33/16, H01L 33/40

(54) **STAPELFÖRMIGES III-V-HALBLEITERZEUG UND HERSTELLUNGSVERFAHREN**
STACK-LIKE III-V SEMICONDUCTOR PRODUCT AND PRODUCTION METHOD
SEMI-CONDUCTEUR III-V EN FORME D'EMPILEMENT ET PROCÉDÉ DE FABRICATION

(30) Priorität: 26.03.2018 DE 102018002426
(43) Veröffentlichungstag der Anmeldung: 25.11.2020
(73) Patentinhaber: AZUR SPACE Solar Power GmbH, 74072 Heilbronn (DE)
(72) Erfinder: STROBL, Gerhard, 70439 Stuttgart (DE)
(74) Vertreter: Koch Müller Patentanwaltsgesellschaft mbH
(86) Internationale Anmeldenummer: PCT/EP2019/000072
(87) Internationale Veröffentlichungsnummer: WO 2019/185190

(56) Entgegenhaltungen:
- US-A1- 2006 083 280
- US-A1- 2012 309 172
- US-A1- 2013 043 214
- US-A1- 2016 141 431
- US-A1- 2016 351 747
- CHEN PENG ET AL: "High crystalline-quality III-V layer transfer onto Si substrate", APPLIED PHYSICS LETTERS, A I P PUBLISHING LLC, US, Bd. 92, Nr. 9, 4. März 2008 (2008-03-04), Seiten 92107-92107, XP012108479, ISSN: 0003-6951, DOI: 10.1063/1.2890494
- SIMPSON TODD W ET AL: "Implantation induced selective chemical etching of indium phosphide", ELECTROCHEMICAL AND SOLID-STATE LETTERS, IEEE SERVICE CENTER, PISCATAWAY, NJ, US; THE INSTITUTION OF ELECTRICAL ENGINEERS, STEVENAGE, GB, Bd. 4, Nr. 3, März 2001 (2001-03), Seiten G26-G27, XP002711243, ISSN: 1099-0062, DOI: 10.1149/1.1346901 [gefunden am 2001-01-25]
- ALTOUKHOV ALEXEI ET AL: "High reflectivity airgap distributed Bragg reflectors realized by wet etching of AlInN sacrificial layers", APPLIED PHYSICS LETTERS, A I P PUBLISHING LLC, US, Bd. 95, Nr. 19, 9. November 2009 (2009-11-09), Seiten 191102-191102, XP012126377, ISSN: 0003-6951, DOI: 10.1063/1.3259720

## Beschreibung

Die Erfindung betrifft ein stapelförmiges III-V-Halbleiterhalbzeug und ein III-V-Halbleiterhalbzeug-Herstellungsverfahren.

Werden Halbleiterbauelemente, insbesondere III-V-Halbleiterbauelemente epitaktisch erzeugt, so bedarf es eines Trägers bzw. Aufwachssubstrats mit geeigneter Kristallstruktur zumindest an der Oberfläche. Je nach Art bzw. Material, aus dem der Träger besteht, ist es wünschenswert, den Träger wiederzuverwenden. Hierzu muss das Halbleiterbauelement nach dem Aufwachsen von dem Träger getrennt werden.

Es ist bekannt, hierfür eine sich ausbildende Grenzfläche zwischen dem Träger und dem aufgewachsenen Halbleiterbauelement oder eine zwischen dem Träger und dem Halbleiterbauelement angeordneter Opferschichtbereich beispielsweise durch Lichteintrag thermisch zu zersetzen. Anschließend können Träger und Halbleiterbauelement entlang der Grenzfläche oder entlang des Opferschichtbereiches getrennt werden.

Entsprechende Halbzeuge und Verfahren sind beispielsweise aus der DE 10 2005 047 152 A1, der DE 196 40 594 A1, der FR 295 4002 A1, der US 7 785 989 B2 oder der DE 10 2008 019 268 A1 bekannt.

Auch sind aus der US 2012 / 309172 A1, aus Chen Peng et al: "High crystalline-quality III-V layer transfer onto Si substrate", Applied Physics Letters, A I P Publishing LLC, US, Bd. 92, Nr. 9, 4. März 2008, Seiten 92107-92107. ISSN: 0003-6951, der US 2006 / 08320 A1, aus Simpson Todd W et al: "Implantation induced selective chemical etching of indium phosphide", Electrochemical and Solid-State Letters, IEEE Service Center, Piscataway, NJ, US, The Institution of Electrical Engineers, Stevenhage, GB, Bd. 4, Nr. 3, März 2001, Seiten G26 - G27, ISSN: 1099-0062, aus Altoukhov Alexei et al: "High refelctivity airgap distributed Bragg reflectors realized by wet etching of AlInN sacrificial layers", Applied Physics Letters, A I P Publishing LLC, US, Bd. 95, Nr. 19, 9. November 2009, Seiten 191102-191102, ISSN: 0003-6951, der US 2016 / 351747 A1, der US 2013 / 043214 A1 und der US 2016 / 141431 A1 weitere Halbzeuge und Verfahren bekannt.

Die US 2006/0185582 A1 offenbart Halbzeuge und Verfahren zum Erzeugen und Transferieren eines dünnen Halbleiterfilms als Ausgangsschicht für weitere Halbleiterschichten.

Aus der US 8,785,294 B2 sind entsprechende Halbzeuge und Verfahren für Silizium basierte Bauelemente bekannt.

Vor diesem Hintergrund besteht die Aufgabe der Erfindung darin, eine Vorrichtung anzugeben, die den Stand der Technik weiterbildet.

Die Aufgabe wird durch ein stapelförmiges III-V-Halbleiterhalbzeug mit den Merkmalen des Patentanspruchs 1 sowie durch ein III-V-Halbleiterhalbzeug-Herstellungsverfahren 8 gelöst. Vorteilhafte Ausgestaltungen der Erfindung sind Gegenstand von Unteransprüchen.

Gemäß dem ersten Gegenstand der Erfindung weist das III-V-Halbleiterhalbzeug ein Substrat mit einem auf einer Oberseite des Substrats angeordneten Opferschichtbereich und einem auf einer Oberseite des Opferschichtbereiches angeordneten Halbleiterschichtbereich auf. Die vorgenannten Halbleiterschichten bilden einen Stapel aus.

Das Substrat und der Opferschichtbereich und der Halbleiterschichtbereich umfassen jeweils mindestens ein chemisches Element aus der Hauptgruppe III und ein chemisches Element aus der Hauptgruppe V.

Wenigstens ein Teil des Opferschichtbereichs unterscheidet sich von dem Substrat und von dem unmittelbar auf der Oberfläche des Opferschichtbereichs angeordneten Teil des Halbleiterschichtbereichs in wenigstens einem Element.

Eine Ätzrate für den Opferschichtbereich unterscheidet sich von einer Ätzrate für das Substrat sowie von einer Ätzrate für die Halbleiterschichtbereich mindestens um einen Faktor 10.

Der Opferschichtbereich umfasst eine durch Implantation erzeugte zumindest teilweise amorphisierte Schicht.

Gemäß dem zweiten Gegenstand der Erfindung wird ein III-V-Halbleiterhalbzeug-Herstellungsverfahren umfassend ein Substrat für die Ausbildung wenigstens eines Halbleiterschichtbereichs bereitgestellt.

Angeordnet auf dem Substrat wird ein Opferschichtbereich zu dem Substrat erzeugt und anschließend wird mittels einer Implantation innerhalb des Opferschichtbereichs eine wenigstens teilweise amorphisierte Schicht erzeugt.

Anschließend wird oberhalb des Opferschichtbereichs ein Halbleiterschichtbereich erzeugt, wobei das Substrat, der Opferschichtbereich und der Halbleiterschichtbereich jeweils mindestens ein chemisches Element aus der Hauptgruppen III und ein chemisches Element aus der Hauptgruppe V aufweisen.

In einem weiteren Prozessschritt wird das Substrat entlang des Opferschichtbereichs von dem Halbleiterschichtbereich abgelöst.

In anderen Prozessschritten wird ein auf dem Substrat und auf dem Halbleiterschichtbereich verbliebener Teil des Opferschichtbereichs mittels eines Ätzprozesses entfernt.

Die Ätzrate unterscheidet sich wenigstens bei einem Teil des Opferschichtbereichs von der Ätzrate für das Substrat sowie von der Ätzrate für den unmittelbar auf der Oberfläche des Opferschichtbereichs angeordneten Teil des Halbleiterschichtbereichs um mindestens einen Faktor 10.

Es sei angemerkt, dass mit dem Ausdruck "auf der Oberseite angeordnet" die Reihenfolge der Schichten festgelegt ist und eine kraftschlüssige Verbindung der Schichten innerhalb des Stapels umfasst ist.

Vorzugsweise ist der Halbleiterschichtbereich ganzflächig auf dem Substrat ausgebildet. In einer Weiterbildung ist der Opferschichtbereich ganzflächig auf dem Substrat ausgebildet.

In einer Ausführungsform sind die jeweiligen Schichten jeweils unmittelbar aufeinander angeordnet, d.h. stoffschlüssig mit einander verbunden. Insbesondere sind in einer Ausführungsform das Substrat und der Opferschichtbereich und der Halbleiterschichtbereich bis zu dem Ablösen monolithisch ausgebildet.

Als Ätzrate für eine bestimmte Ätzlösung oder für einen Trockenätzprozess (RIE-Ätzung) wird ein Ätzabtrag pro Zeit bezeichnet. Es versteht sich, dass der Ätzabtrag für ein Material richtungsabhängig bzw. anisotrop sein kann.

Unterscheiden sich zwei Materialien hinsichtlich ihrer Ätzrate für die bestimmte Ätzlösung bzw. Trockenätzprozess, so spricht man auch von einer Selektivität oder auch chemischer Selektivität zwischen den beiden Materialien. Die Selektivität wird typischerweise als Verhältnis der Ätzraten der beiden Materialien angegeben.

Die unterschiedlichen Ätzraten ermöglichen ein einfaches und zuverlässiges Entfernen von Überresten des Opferschichtbereichs, ohne dass das Substrat oder der Halbleiterschichtbereich angeätzt werden.

Bevorzugt wird als Ätzprozess ein nasschemisches Ätzverfahren mit einer Ätzlösung, beispielsweise mit Ammoniak und Wasserstoffperoxid oder Kaliumhydroxid oder Salzsäure durchgeführt.

Es versteht sich, dass der Opferschichtbereich als Sollbruchstelle dient und das Ablösen des Halbleiterschichtbereiches von dem Substrat wesentlich erleichtert. Eine Beschädigung des Halbleiterbereichs oder des Substrats wird vermieden.

Bevorzugt sind die Schichten jeweils mittels Epitaxie auf dem Substrat gewachsen, z.B. mittels Flüssigphasenepitaxie oder mittels Metallorganischer Gasphasenepitaxie (MOVPE oder MOCVD). Es versteht sich, dass bei der Epitaxie die Wachstumstemperatur möglichst gering gewählt wird.

Insbesondere liegt die Wachstumstemperatur für die Schicht oder die Schichten des Halbleiterbereichs unterhalb der Ausheiltemperatur der amorphisierten Schicht. Vorzugsweise beträgt die Wachstumstemperatur für den Halbleiterbereich kleiner als 600°C. Niedrige Wachstumstemperaturen lassen sich insbesondere mit hydridfreien Quellen erreichen.

Ein Vorteil der Erfindung ist, dass sich der Halbleiterschichtbereich auf einfache Weise von der Substratfolge trennen lässt. Hierdurch können in wirtschaftlich sinnvoller Weise auch Substrate aus relativ teuren Materialien, z.B. einem GaN-Substrat oder einem InP-Substrat oder einem GaAs-Substrat oder weitere III-V-Substrate für das Erzeugen eines Schichtaufbaus verwendet werden.

Im Unterschied zu der US 2006/0185582 A1 werden vorliegend auf einem Ausgangssubstrat angeordnete Opferschicht bzw. zwischen einer Geberschicht und dem Ausgangssubstrat angeordnete Opferschicht in vorteilhafter Weise verwendet. Hierdurch lassen sich Bauelemente wesentlich kostengünstiger erzeugen und die Umwelt wird erheblich weniger belastet.

Auch sei angemerkt, dass die Entwicklung von Bauelementen auf der Basis von III-V-Halbleitern ein völlig unterschiedliches technisches Gebiet im Vergleich zu der Entwicklung von Silizium basierten Bauelemente betrifft. Anders ausgedrückt, eine Entwicklung von III-V Bauelemente bedingt jahrelange Kenntnis insbesondere der MOVPE-Epitaxie Verfahren. Insbesondere besitzt ein Expitaxiefachmann für Silizium genau keine Kenntnisse auf dem Gebiet der III-V MOVPE Epitaxie. Die Chemie und die Prozesse und die Eigenschaften der Schichten sind völlig unterschiedlich.

Aufgrund der erheblichen Unterschiede der Herstellungsverfahren für Silizium und beispielsweise Galliumarsenid lassen sich Verfahren bei Silizium sich nicht auf Galliumarsenid übertragen. Silizium basierte Veröffentlichungen lassen sich vorliegend nicht als Stand der Technik ansehen.

Ein weiterer Vorteil ist, dass sich die teueren GaN- oder InP- oder GaAs- Substrate nicht oder nahezu nicht verbrauchen und hierdurch beliebig oft als Wachstumskeimlinge für die Epitaxie von den nachfolgenden Schichten verwenden lassen.

Ein anderer Vorteil ist, dass sich ein Dünnen einer Substrat-Halbleiterscheibe vermeiden lässt. Hierdurch lassen sich erheblich Ressourcen einsparen, als auch ein Einbringen von problematischen Stoffen wie beispielsweise GaAs oder InP oder GaN in die Umwelt weitestgehend vermeiden.

In einer Weiterbildung unterscheidet sich die Ätzrate für wenigstens einen Teil des Opferschichtbereichs von der Ätzrate für das Substrat sowie von der Ätzrate für den Halbleiterschichtbereich um mindestens einen Faktor 100 oder mindestens um einen Faktor 1000.

In einer Weiterbildung umfasst der Opferschichtbereich mehrere stapelförmig aufeinander angeordnete Opferschichten. Vorzugsweisen weisen die in direktem Kontakt zu dem Substrat und / oder zu dem Halbleiterbereich stehenden Opferschichten eine chemische Selektivität, insbesondere nasschemische Selektivität zu den weiteren Schichten des Opferschichtbereichs auf. Vorzugswiese weisen die in direktem Kontakt zu dem Substrat und / oder zu dem Halbleiterbereich stehenden Opferschichten eine niedrigere Ätzrate als die weiteren Opferschichten auf.

In einer Ausführungsform sind die in direktem Kontakt zu dem Substrat und / oder zu dem Halbleiterbereich stehenden Opferschichten vorzugsweise dünner ausgebildet als die weiteren Opferschichten. Vorzugsweise sind die weiteren Opferschichten in der Mitte oder in der Nähe der Mitte des Opferschichtbereichs angeordnet.

In einer Ausführungsform verbleiben die in direktem Kontakt zu dem Substrat und / oder zu dem Halbleiterbereich stehenden Opferschichten auf dem Halbleiterbreich bzw. auf dem Substrat. Insofern sind zwar die in direktem Kontakt zu dem Substrat und / oder zu dem Halbleiterbereich stehenden Opferschichten aus Gründen der Übersichtlichkeit dem Opferschichtbereich zugeordnet werden jedoch nicht geopfert.

In einer anderen Weiterbildung ist ein Teil oder der gesamte Opferschichtbereich zu dem Substrat und zu wenigstens einem Teil des Halbleiterschichtbereichs gitterangepasst. Vorzugsweise ist der gesamte Halbleiterschichtbereich zu dem Substrat gitterangepasst.

In einer anderen Ausführungsform umfasst oder besteht der Opferschichtbereich aus einem metamorphen Puffer. Wobei die Gitterkonstante der metamorphen Pufferstruktur wenigstens teilweise mit der Gitterkonstante des Substrats übereinstimmt.

In einer nicht erfindungsgemäßen Ausführungsform umfasst der Opferschichtbereich eine erste Opferschicht und / oder eine zweite Opferschicht und / oder eine dritte Opferschicht.

In einer nicht erfindungsgemäßen Weiterbildung umfasst der Opferschichtbereich wenigstens eine Schicht oder genau eine Schicht. Vorzugsweise umfasst oder besteht die Schicht aus einer oder mehreren der folgenden Verbindungen (Al)GaAs, InGaAs, InP, AlAs, GaInP, In₁₈Al₈₂N.

Erfindungsgemäß umfasst der Opferschichtbereich genau drei Opferschichten.

Erfindungsgemäß umfassen oder bestehen die beiden äußeren Schichten aus InGaAs oder AlAs oder GaInP oder AlGaAs. Erfindungsgemäß umfasst oder besteht die mittlere Opferschicht aus GaAs.

In einer Ausführungsform weist der Opferschichtbereich eine Schichtdicke von 0,1 µm - 10 µm oder vorzugsweise von 1 µm - 3 µm auf.

Erfindungsgemäß wird die amorphisierte Schicht in der Nähe der Mitte oder in der Mitte des Opferschichtbereichs ausgebildet. Vorzugsweise wird die amorphisierte Schicht unter Verwendung von einem Protonenstrahl erzeugt. Es sei angemerkt, dass sich ein Protonenstrahl einfach und kostengünstig mit einer Wasserstoffquelle erzeugen lässt.

Alternativ sind auch andere Ionen für eine Amorphisierung geeignet. Beispielsweise lassen sich auch Bor- oder Arsenatome implantieren. Es versteht sich, dass hierzu die Elemente vor der Implantation jeweils ionisiert werden. In einer anderen Weiterbildung liegt die Energie für die Implantation in einem Bereich zwischen 20 keV und 500 keV. Vorzugsweise liegt die Dosis zwischen 1e14 /cm² und 1e16 /cm².

In einer Weiterbildung besteht das Substrat aus GaN oder aus GaAs oder aus InP. Anstelle einer Halbleiterscheibe als Substrat aus InP, die sehr brüchig ist und daher schwer prozessierbar, ist nur an der Oberfläche einer GaAs Halbleiterscheibe eine Schicht aus InP. Ein derartiger Aufbau wird auch als virtuelles Substrat bezeichnet. Ein Vorteil ist, dass sich hierdurch erhebliche Kosten einsparen lassen.

Gemäß einer Ausführungsform weist das Substrat und der Halbleiterschichtbereich als chemisches Element aus der Hauptgruppe V jeweils As und / oder P und / oder N und als chemisches Element aus der Hauptgruppe III jeweils In und / oder Ga auf. Zusätzlich umfasst der Opferschichtbereich Al.

In einer Ausführungsform weist der Halbleiterschichtbereich eine Schichtdicke von 0,3 µm - 200 µm oder von 0,3 µm - 30 µm oder von 1 µm bis 5 µm auf. Ein Vorteil ist, dass sich in dem Halbleiterschichtbereich elektronische Bauelemente ausbilden lassen.

In einer anderen Weiterbildung umfasst der Halbleiterschichtbereich eine Vielzahl von Halbleiterschichten insbesondere III-V-Halbleiterschichten. Ein Vorteil ist, dass sich hierdurch vorzugsweise GaAs Bauelemente oder aufrechte Mehrfachsolarzellen (UMM-Solarzellen) oder umgekehrte Mehrfachsolarzellen (IMM-Solarzellen, ILM-Solarzellen) oder GaN-HEMT oder GaN-LEDs oder GaN-Laser auf einfache und kostengünstige Weise ausbilden lassen. Vorzugsweise lassen sich IR High-Power LED ausbilden.

Bei einer IMM (inverted-metamorphic-mulitjuction) oder ILM (invertedlattice-matched) Solarzelle ist die Unterseite der Halbleiterschichtbereich nachfolgend die Oberseite des Stapels, d.h. das Sonnenlicht trifft zuerst auf die Oberseite des Stapels. Hierzu wird nach dem Ablösen der Stapel umgedreht. Auch bei der Ausbildung einer IR-High Power LED wird der Stapel umgedreht.

In einer anderen Weiterbildung wird vor dem Ablösen eine Trägerschicht stoffschlüssig auf einer Oberseite des Halbleiterschichtbereichs angeordnet. Vorzugsweise ist die Trägerschicht entsprechend nur temporär auf der Oberseite angeordnet.

In einer Ausführungsform wird vor oder anstelle der Verbindung mit einer Trägerschicht auf der Oberseite des Halbleiterbereichs eine dielektrische Schicht und oder metallische Schichten angeordnet. Hierbei dient die dielektrische Schicht vorzugsweise als Passivierungsschicht, die metallische Schicht beispielsweise als Kontaktschicht.

In einer Ausführungsform ist die metallische Schicht als Spiegelschicht ausgebildet. Insbesondere für die Ausbildung einer IR-LED-Struktur oder einer IMM-Struktur oder einer ILM-Struktur ist das vorteilhaft.

Vorzugsweise sind die metallische Schicht und die Passivierungsschicht auch strukturiert ausgebildet. Insbesondere lässt sich die Kontaktschicht als Fingerstruktur ausbilden.

Es sei angemerkt, dass sich eine Vielzahl von unterschiedlichen Materialien als Trägerschicht eignet. Ein besonders günstiges und gebräuchliches Material ist beispielsweise Silizium oder Kunststoff oder Glas oder Germanium oder eine Metallfolie oder ein Verbundmaterial. Es versteht sich, dass sich die thermischen Ausdehnungskoeffizienten der Trägerschicht und des Material des Halbleiterbereichs sich vorzugsweise nur wenig unterscheiden, um Spannungen und Risse in dem Halbleiterbereich möglichst zu vermeiden.

Die Trägerschicht dient insbesondere als eine mechanische Stabilisierung des abzulösenden Halbleiterschichtbereichs. Hierdurch lassen sich Risse und Defekte bedingt durch den Ablöseprozess auf einfache und kostengünstige Weise zuverlässig vermeiden.

Umfasst der Halbleiterbereich eine IMM- oder ILM-Solarzellen-Struktur ist es vorteilhaft, die Trägerschicht als unterseitige Substratschicht auszubilden. Vorzugsweise umfasst die Trägerschicht eine metallische Kontaktschicht. Bei der Solarzellenstruktur umfasst die metallische Kontaktschicht insbesondere auch den rückseitigen Anschluss der Mehrfachsolarzellenstruktur und/oder einen Spiegel.

Nach dem Ablösen von dem Substrat werden die auf dem Halbleiterschichtbereich und die auf dem Substrat verbliebenen Teile des Opferschichtbereiches mittels eines Ätzprozesses entfernt. In einer anderen Ausführungsform werden CMP-Prozesse mit in die Entfernung von Resten des Opferschichtbereichs eingesetzt.

In einer Weiterbildung wird das Ablösen mechanisch initiiert. Hierzu wirkt seitlich in der Höhe und entlang des Opferschichtbereichs ein mechanischer Impuls auf die Schichtstruktur ein.

In einer Weiterbildung werden nach dem Ablösen die auf dem Substrat und die auf dem Halbleiterschichtbereich verbliebenen Teile des Opferschichtbereichs mittels eines Ätzprozesses entfernt und das Substrat wird für eine neuerliche Verwendung (re-use) bereitgestellt. Insbesondere bei der Verwendung von naßchemischen Ätzverfahren lassen sich die Reste von dem Opferschichtbereich von dem Substrat und dem Halbleiterschichtbereich einfach, kostengünstig und schnell entfernen.

Vorzugsweise wird nach dem Entfernen der Reste der Opferschichte ein weiterer chemischer Prozess und / oder Reinigungsschritt und / oder Oxidationsschritt durchgeführt, um die Oberfläche des Substrats für eine erneute Epitaxie (epi-ready) vorzubereiten.

In einer Ausführungsform verbleibt eine dünne Opferschicht unmittelbar auf dem Substrat. Die dünne Opferschicht weist eine hohe chemische Selektivität, insbesondere nasschemische Selektivität, gegenüber wenigstens einem Teil von den anderen Schichten oder Schichtresten des Opferschichtbereichs auf.

In einer Ausführungsform wird nach dem Ablösen die von den Resten des Opferschichtbereichs befreite Oberfläche des Halbleiterschichtbereichs auf einem Träger stoffschlüssig angeordnet.

In einer Ausführungsform verbleibt eine dünne Opferschicht unmittelbar auf dem Halbleiterschichtbereich. Die dünne Opferschicht weist eine hohe chemische Selektivität, insbesondere nasschemische Selektivität, gegenüber wenigstens einem Teil von den anderen Schichten oder Schichtresten des Opferschichtbereichs auf.

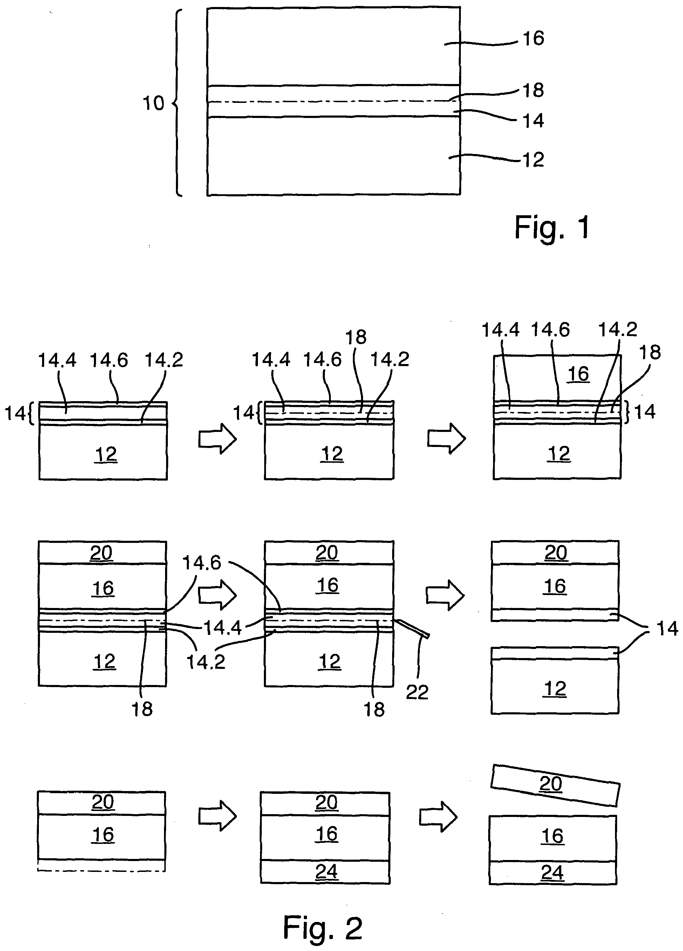

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände sowie die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Ansicht einer Ausführungsform eines erfindungsgemäßen III-V-Halbleiterhalbzeugs,
- Figur 2: eine Ansicht einer Ausführungsform eines erfindungsgemäßen Herstellungsverfahrens,
- Figur 3: eine Ansicht auf eine Ausführungsform einer IR-LED Struktur jeweils vor dem Ablösen,
- Figur 4: eine Ansicht auf eine Ausführungsform einer ILM- gitterangepassten zweifach Solarzellenstruktur vor dem Ablösen,
- Figur 5: eine Ansicht einer Ausführungsform einer IMM-vierfach Solarzelle vor dem Ablösen.
Die Abbildung der Figur 1 zeigt eine Ausführungsform eines III-V-Halbleiterhalbzeugs 10, umfassend eine GaAs-Halbleiterscheibe als Substrat 12, ein Opferschichtbereich 14 umfassend eine AlGaAs-Schicht, und ein Halbleiterschichtbereich 16 umfassend eine GaAs-Schicht. Der Opferschichtbereich 14 umfasst eine durch Implantation erzeugte wenigstens teilweise oder vollständig amorphisierte Schicht 18. In einer nicht dargestellten Ausführungsform umfasst der Opferschichtbereich 14 genau zwei Halbleiterschichten oder genau drei Halbleiterschichten. Die amorphisierte Schicht 18 ermöglicht ein einfaches Trennen des Halbleiterschichtbereichs 16 von dem Substrat 12.

Es sei angemerkt, dass sich anstelle einer GaAs-Halbleiterscheibe auch eine GaN-Halbleiterscheibe oder ein InP-Halbleiterscheibe oder eine andere III-V Halbleiterscheibe als Substrat 12 verwenden lässt. Anstelle einer Halbleiterscheibe aus InP umfasst das Substrat 12 in einer nicht dargestellten Ausführungsform nur an der Oberfläche einer GaAs Halbleiterscheibe eine Schicht aus InP. Ein derartiger Aufbau wird auch als virtuelles Substrat bezeichnet. Ein Vorteil ist, dass sich hierdurch die mechanische Stabilität erhöhen läßt und erhebliche Kosten einsparen lassen.

Die chemische Zusammensetzung bzw. die Stöchiometrie des Opferschichtbereiches wird vorzugsweise entsprechend des Substrates 12 gewählt, sodass sich der Opferschichtbereich vorzugsweise gitterangepasst zu dem jeweiligen Substrat 12 ausbilden und hinsichtlich eines nachfolgenden Ätzprozesses sich besonders selektiv zu dem Opferschichtbereich 14 und dem Substrat 12 entfernen lässt.

Die Abbildung der Figur 2 zeigt eine Ausführungsform eines erfindungsgemäßen III-V-Halbleiterhalbzeug-Herstellungsverfahrens. Auf dem Träger 12 wird durch Epitaxie ein Opferschichtbereich 14 mit einer ersten Opferschicht 14.2 und einer zweiten Opferschicht 14.4 und einer dritten Opferschicht 14.6 erzeugt.

Innerhalb der zweiten Opferschicht 14.4 wird durch Implantation die wenigstens teilweise oder vollständig amorphisierte Schicht 18 erzeugt. Hierbei lässt sich der Implantationsschritt sowohl unmittelbar nach der Herstellung der zweiten Opferschicht 14.4 als nach der Herstellung der dritten Opferschicht durchführen.

Anschließend wird der Halbleiterschichtbereich 16 auf dem Opferschichtbereich 14 vorzugsweis epitaktisch aufgewachsen.

In einer nicht dargestellten Ausführungsform umfasst der Halbleiterschichtbereich 16 entsprechend einer vorgesehenen Anwendung mehrere oder eine Vielzahl von Halbleiterschichten. Die Halbleiterschichten sind vorzugsweise epitaktisch stapelförmig aufeinander angeordnet.

Insbesondere lassen sich ohne weiteres die Halbleiterschichten z.B. für ein GaN-HEMT oder eine GaN-LED oder für die Ausbildung einer Mehrfachsolarzelle insbesondere einer inverted metamorphic Mehrfachsolarzelle verwenden.

Zur Ausbildung einer IMM Solarzelle werden die Halbleiterschichten hinsichtlich der Reihenfolge der Bandlücken in einem Vergleich zu herkömmlichen Solarzellen invertiert aufgewachsen.

Anschließend wird die Oberseite des Halbleiterschichtbereichs 16 mit einer Trägerschicht 20 stoffschlüssig verbunden.

Vorzugsweise, sofern der Halbleiterschichtbereich 16 dünn ist, d.h. mechanisch instabil ist, oder aber auch aus anderen Gründen ist das Aufbringen der Trägerschicht 20 von Vorteil.

Anschließend wird der Opferschichtbereich 14 mechanisch mittels eines Werkzeugs 22 seitlich vorzugsweise in der Höhe der amorphisierten Schicht 18 eingekerbt und der Halbleiterschichtbereich 16 mit der Trägerschicht 20 von Substrat 12 entlang des Opferschichtbereichs 14 getrennt.

In einer nicht dargestellten Ausführungsform wird nach der Ausbildung der amorphisierten Schicht 18 und / oder nach der Ausbildung von weiteren Halbleiterschichten, jedoch vor dem Ablösen durch einen Ätzprozess ein umlaufender Randbereich von dem Opferschichtbereich 14 wieder entfernt, so dass der Schichtstapel bei dem Opferschichtbereich 14 eine zurückgesetzte Stufe 18 aufweist.

Sowohl auf dem Substrat 12 als auch auf dem Halbleiterschichtbereich 16 verbleiben nach dem Ablösen Teile des Opferschichtbereichs 14.

Die verbliebenen Teile des Opferschichtbereichs 14 werden durch Ätzen von der Trägerschicht 12 und dem Halbleiterschichtbereich 16 entfernt (nur für den auf dem Halbleiterschichtbereich 16 verbliebenen Teil des Opferschichtbereiches 14 als eine gestrichelte Linie dargestellt).

In einer Weiterbildung wird nach dem vollständigen Entfernen des Opferschichtbereichs 14 von dem Halbleiterschichtbereich 16 die Unterseite des Halbleiterschichtbereichs 16 auf einem Träger 24 wenigstens kraftschlüssig angeordnet und die Trägerschicht 20 entfernt.

Vorzugsweise wird bei dem Anordnen des Halbleiterschichtbereichs 16 auf einem Träger 24, beispielsweise durch Waferbonden oder durch Metallbonden, der Halbleiterschichtbereich 16 mit einem Träger 24 stoffschlüssig verbunden.

Nach dem Entfernen der Reste des Opferschichtbereichs 14 von dem Substrat 12 steht das Substrat 12 für eine erneute Epitaxie zur Verfügung (nicht dargestellt).

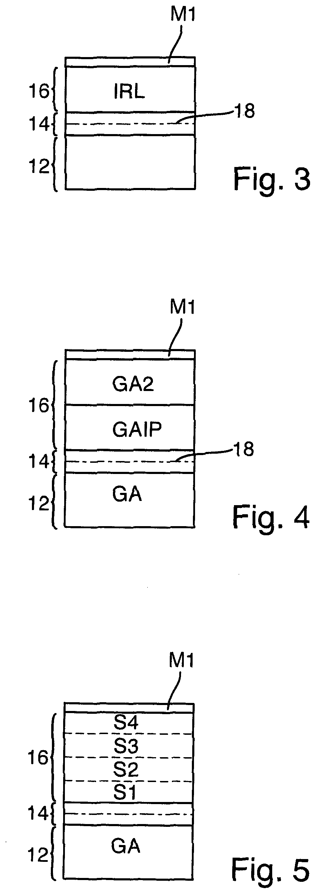

Die Abbildung der Figur 3 zeigt eine Ausführungsform einer IR-LED Struktur vor dem Ablösen. In der Ausführungsform wird auf dem als GaAs ausgebildeten Substrat 12 eine Opferschicht 14 aus AlGaAs hergestellt und anschließend mittels einer Implantation eine in der Mitte der Opferschicht 14 amorphisierte Schicht erzeugt. Anschließend wird eine IR-LED Schichtstruktur IRL umfassender Halbleiterbereich 16 epitaktisch erzeugt.

Anschließend wir auf der Oberseite des Stapels eine ganzflächige metallische Schicht M1 abgeschieden.

Die Abbildung der Figur 4 zeigt eine Ausführungsform einer ILM gitterangepassten Zweifachsolarzellenstruktur vor dem Ablösen. Der Halbleiterbereich 16, umfasst eine ersten Teilzelle GAIP mit GaInP und eine zweite Teilzelle GA2 mit GaAs ausgebildet auf einer Opferschicht GA aus GaAs.

In einer nicht dargestellten Ausführungsform ist zwischen der ersten Teilzelle GAIP und der GaAs-Opferschicht eine weitere Opferschicht aus AlInGaP ausgebildet. Vorteilhaft ist, dass die weitere Opferschicht aus AlInGaP- eine nasschemische Selektivität zu der GaAs-Opferschicht aufweist.

Beide Teilsolarzellen und die Opferschicht sind gitterangepasst zu dem Substrat und monolithisch gestapelt. Es versteht sich, dass zwischen den beiden Teilsolarzellen eine Tunneldiode (nicht dargestellt) ausgebildet ist und die GaInP-Teilzelle eine größere Bandlücke als die GaAs Teilzelle aufweist. Auf der Oberseite ist die metallische Schicht M1 oder ein Halbleiterspiegel ausgebildet.

In der Ausführungsform, dargestellt in der Figur 5, ist eine IMM-vierfach Solarzellenstruktur vor dem Ablösen dargestellt. Im Folgenden werden nur die Unterschiede zu der Ausführungsform dargestellt in der Figur 4 erläutert. Der Halbleiterbereich 16 umfasst vier Teilsolarzellen S1 bis S4. Es versteht sich, dass zwischen den einzelnen Teilsolarzellen jeweils eine Tunneldiode (nicht dargestellt) ausgebildet ist und die S1-Teilzelle eine größere Bandlücke als die S2 Teilzelle und die S2 Teilzelle eine größere Bandlücke als die S3 Teilzelle und die S3 Teilzelle eine größere Bandlücke als die S4 Teilzelle aufweist. Die Teilsolarzellen S1 bis S4 sind vorzugsweise monolithisch ausgebildet.

## Patentansprüche

1. Stapelförmiges III-V-Halbleiterhalbzeug (10), aufweisend
- ein Substrat (12),
- einen auf dem Substrats (12) angeordneten Opferschichtbereich (14),
- einen auf einer Oberfläche des Opferschichtbereichs (14) angeordneten Halbleiterschichtbereich (16), wobei
- das Substrat (12), der Opferschichtbereich (14) und der Halbleiterschichtbereich (16) jeweils mindestens ein chemisches Element aus der Hauptgruppe III und ein chemisches Element aus der Hauptgruppe V umfassen,
- wenigstens ein Teil des Opferschichtbereichs (14) sich von dem Substrat (12) und von dem unmittelbar auf der Oberfläche des Opferschichtbereichs angeordneten Teil des Halbleiterschichtbereichs (16) in wenigstens einem Element unterscheidet,
- eine Ätzrate für einen vorgegebenen Ätzprozess wenigstens für einen Teil des Opferschichtbereichs (14) sich von der Ätzrate für das Substrat (12) und von der Ätzrate für den unmittelbar auf der Oberfläche des Opferschichtbereichs angeordneten Teil des Halbleiterschichtbereichs (16) um mindestens einen Faktor 10 unterscheidet, **dadurch gekennzeichnet, dass**
- der Opferschichtbereich (14) eine durch Implantation erzeugte zumindest teilweise amorphisierte Schicht (18) umfasst,
- die amorphisierte Schicht (18) in der Nähe der Mitte oder in der Mitte des Opferschichtbereichs (14) angeordnet ist und
- der Opferschichtbereich (14) genau drei Opferschichten (14.2, 14.4, 14.6) umfasst und die beiden äußeren Schichten (14.2, 14.6) InGaAs oder AlAs oder GaInP oder AlGaAs umfassen oder aus InGaAs oder AlAs oder GaInP oder AlGaAs bestehen und die mittlere Opferschicht (14.4) GaAs umfasst oder aus GaAs besteht.

2. Stapelförmiges III-V-Halbleiterhalbzeug (10) nach Anspruch 1, **dadurch gekennzeichnet, dass** sich die Ätzraten um mindestens einen Faktor 100 oder mindestens um einen Faktor 1000 unterscheiden.

3. Stapelförmiges III-V-Halbleiterhalbzeug (10) nach Anspruch 1 oder Anspruch 2, **dadurch gekennzeichnet, dass** der Opferschichtbereich (14) mehrere stapelförmig aufeinander angeordnete Opferschichten umfasst.

4. Stapelförmiges III-V-Halbleiterhalbzeug (10) nach einem der Ansprüche 1 bis 3, **dadurch gekennzeichnet, dass** wenigstens ein Teil oder der gesamte Opferschichtbereich (14) mit Ausnahme der amorphisierten Schicht (18) zu dem Substrat (12) und zu wenigstens einem Teil des Halbleiterschichtbereichs (16) gitterangepasst ist.

5. Stapelförmiges III-V-Halbleiterhalbzeug (10) nach einem der Ansprüche 1 bis 4, **dadurch gekennzeichnet, dass** der Opferschichtbereich (14) eine Schichtdicke von 0,1 µm - 10 µm oder von 1 µm - 3 µm aufweist.

6. Stapelförmiges III-V-Halbleiterhalbzeug (10) nach einem der Ansprüche 1 bis 5, **dadurch gekennzeichnet, dass** das Substrat (12) aus GaN oder aus GaAs oder aus InP besteht.

7. Stapelförmiges III-V-Halbleiterhalbzeug (10) nach einem der Ansprüche 1 bis 6, **dadurch gekennzeichnet, dass** der Halbleiterschichtbereich (16) eine Schichtdicke von 0,3 µm - 30 µm oder von 1 µm bis 5 µm aufweist.

8. III-V-Halbleiterhalbzeug (10)-Herstellungsverfahren, wobei
- ein Substrat (12) bereitgestellt wird,
- auf dem Substrat (12) ein Opferschichtbereich (14) gitterangepasst zu dem Substrat (12) erzeugt wird,
- wobei der erzeugte Opferschichtbereich (14) genau drei Opferschichten (14.2, 14.4, 14.6) umfasst und die beiden äußeren Schichten (14.2, 14.6) InGaAs oder AlAs oder GaInP oder AlGaAs umfassen oder aus InGaAs oder AlAs oder GaInP oder AlGaAs bestehen und die mittlere Opferschicht (14.4) GaAs umfasst oder aus GaAs besteht,
- anschließend mittels einer Implantation innerhalb des Opferschichtbereichs (14) in der Nähe der Mitte oder in der Mitte des Opferschichtbereichs (14) eine wenigstens teilweise amorphisierte Schicht (18) erzeugt wird,
- anschließend ein Halbleiterschichtbereich (16) erzeugt wird, wobei das Substrat, der Opferschichtbereich (14) und der Halbleiterschichtbereich (16) jeweils mindestens ein chemisches Element aus der Hauptgruppen III und ein chemisches Element aus der Hauptgruppe V aufweisen,
- das Substrat (12) entlang des Opferschichtbereichs (14) von der Halbleiterschichtbereich (16) abgelöst wird,
- ein auf den Substrat (12) und auf dem Halbleiterschichtbereich (16) verbliebener Teil der Opferschichtbereich (14) mittels eines Ätzprozesses entfernt wird, wobei sich die Ätzrate wenigstens für einen Teil des Opferschichtbereichs (14) von der Ätzrate für das Substrat sowie von der Ätzrate für den unmittelbar auf der Oberfläche des Opferschichtbereichs angeordneten Teil des Halbleiterschichtbereichs (16) um mindestens einen Faktor 10 unterscheidet.

9. III-V-Halbleiterhalbzeug-Herstellungsverfahren nach Anspruch 8, **dadurch gekennzeichnet, dass** wenigstens ein Teil oder der gesamte Opferschichtbereich (14) mit Ausnahme der amorphisierten Schicht (18) zu dem Substrat (12) und zu wenigstens einem Teil des Halbleiterschichtbereichs (16) gitterangepasst ist.

10. III-V-Halbleiterhalbzeug-Herstellungsverfahren nach einem der Ansprüche 8 oder 9, **dadurch gekennzeichnet, dass** die amorphisierte Schicht (18) unter Verwendung von einem Protonenstrahl erzeugt wird.

11. III-V-Halbleiterhalbzeug-Herstellungsverfahren nach einem der Ansprüche 8 bis 10, **dadurch gekennzeichnet, dass** die Implantation mit einer Energie in einem Bereich zwischen 20 keV und 500 keV und die Dosis zwischen 1e14 /cm² und 1e16 /cm² durchgeführt wird.

12. III-V-Halbleiterhalbzeug-Herstellungsverfahren nach einem der Ansprüche 8 bis 11, **dadurch gekennzeichnet, dass** das Ablösen mechanisch initilert wird und in dem Teil des Opferschichtbereichs (14) durchgeführt wird.

13. III-V-Halbleiterhalbzeug-Herstellungsverfahren nach einem der Ansprüche 8 bis 12, **dadurch gekennzeichnet, dass** vor dem Ablösen die Halbleiterschichtbereich (16) auf der Oberseite der Halbleiterschichtbereich eine Trägerschicht (20) angeordnet wird.

14. III-V-Halbleiterhalbzeug-Herstellungsverfahren nach einem der Ansprüche 8 bis 13, **dadurch gekennzeichnet, dass** nach dem Ablösen der Halbleiterschichtbereich mit der von Resten der Opferschichtbereich (14) befreiten Oberfläche auf einem Träger (24) angeordnet wird.

15. III-V-Halbleiterhalbzeug-Herstellungsverfahren nach einem der Ansprüche 8 bis 14, **dadurch gekennzeichnet, dass** nach dem Ablösen die auf dem Substrat (12) verbliebenen Teile des Opferschichtbereichs (14) entfernt werden und das Substrat (12) für eine neuerliche Verwendung bereitgestellt wird.

16. III-V-Halbleiterhalbzeug-Herstellungsverfahren nach einem der Ansprüche 8 bis 15, **dadurch gekennzeichnet, dass** der Halbleiterschichtbereich (14) auf einem Trägersubstrat stoffschlüssig angeordnet wird.

## Claims

1. Stack-shaped lll-V semiconductor semi-finished product (10), comprising
- a substrate (12),
- a sacrificial layer region (14) arranged on the substrate (12),
- a semiconductor layer region (16) arranged on a surface of the sacrificial layer region (14), wherein
- the substrate (12), the sacrificial layer region (14) and the semiconductor layer region (16) each comprise at least one chemical element from the main group III and chemical element from the main group V,
- at least a part of the sacrificial layer region (14) differs in at least one element from the substrate (12) and from the part of the semiconductor layer region (16) arranged directly on the surface of the sacrificial layer region,
- a rate of etching for a predetermined etching process at least for a part of the sacrificial layer region (14) differs by at least a factor 10 from the rate of etching for the substrate (12) and from the rate of etching for the part of the semiconductor layer region (16) arranged directly on the surface of the sacrificial layer region,
**characterised in that**
- the sacrificial layer region (14) comprises an at least partly amorphised layer (18) produced by implantation,
- the amorphised layer (18) is arranged in the proximity of the centre or in the centre of the sacrificial layer region (14) and
- the sacrificial layer region (14) comprises exactly three sacrificial layers (14.2, 14.4, 14.6) and the two outer layers (14.2, 14.6) comprise InGaAs or AlAs or GaInP or AIGaAs or consist of InGaAs or AlAs or GaInP or AlGaAs and the middle sacrificial layer (14.4) comprises GaAs or consists of GaAs.

2. Stack-shaped lll-V semiconductor semi-finished product (10) according to claim 1, **characterised in that** the rates of etching differ by at least a factor 100 or at least by a factor 1000.

3. Stack-shaped III-V semiconductor semi-finished product (10) according to claim 1 or claim 2, **characterised in that** the sacrificial layer region (14) comprises a plurality of sacrificial layers arranged in stack shape one on the other.

4. Stack-shaped III-V semiconductor semi-finished product (10) according to any one of claims 1 to 3, **characterised in that** at least a part of or the entire sacrificial layer region (14) with the exception of the amorphised layer (18) is lattice-matched to the substrate (12) and to at least a part of the semiconductor layer region (16).

5. Stack-shaped III-V semiconductor semi-finished product (10) according to any one of claims 1 to 4, **characterised in that** the sacrificial layer region (14) has a layer thickness of 0.1 µm - 10 µm or of 1 µm - 3 µm.

6. Stack-shaped III-V semiconductor semi-finished product (10) according to any one of claims 1 to 5, **characterised in that** the substrate (12) consists of GaN or of GaAs or of InP.

7. Stack-shaped III-V semiconductor semi-finished product (10) according to any one of claims 1 to 6, **characterised in that** the semiconductor layer region (16) has a layer thickness of 0.3 µm - 30 µm or of 1 µm - 5 µm.

8. III-V semiconductor semi-finished product (10) production method, wherein
- a substrate (12) is provided,
- a sacrificial layer region (14) lattice-matched to the substrate (12) is produced on the substrate (12),
- wherein the produced sacrificial layer region (14) comprises exactly three sacrificial layers (14.2, 14.4, 14.6) and the two outer layers (14.2, 14.6) comprise InGaAs or AlAs or GaInP or AlGaAs or consist of InGaAs or AlAs or GaInP or AlGaAs and the middle sacrificial layer (14.4) comprises GaAs or consists of GaAs,
- at least one partly amorphised layer (18) is subsequently produced by means of implantation within the sacrificial layer region (14) in the proximity of the centre or in the centre of the sacrificial layer region (14),
- a semiconductor layer region (16) is subsequently produced, wherein the substrate, the sacrificial layer region (14) and the semiconductor layer region (16) each comprise at least one chemical element from the main groups III and chemical element from the main groups V,
-- the substrate (12) is detached from the semiconductor layer region (16) along the sacrificial layer region (14),
- a part of the sacrificial layer region (14) remaining on the substrate (12) and on the semiconductor layer region (16) is removed by means of an etching process, wherein the rate of etching at least for a part of the sacrificial layer region (14) differs by at least a factor 10 from the rate of etching for the substrate as well as from the rate of etching for the part of the semiconductor layer region (16) arranged directly on the surface of the sacrificial layer region.

9. III-V semiconductor semi-finished production method according to claim 8, **characterised in that** at least a part of or the entire sacrificial layer region (14) with the exception of the amorphised layer (18) is lattice-matched to the substrate (12) and to at least a part of the semiconductor layer region (16).

10. III-V semiconductor semi-finished production method according to one of claims 8 and 9, **characterised in that** the amorphised layer (18) is produced with use of a proton beam.

11. III-V semiconductor semi-finished production method according to any one of claims 8 to 10, **characterised in that** the implantation is carried out with an energy in a range between 20 keV and 500 keV and a dose between 1e14 / cm² and 1e16 / cm².

12. III-V semiconductor semi-finished production method according to any one of claims 8 to 11, **characterised in that** the detaching is initiated mechanically and is performed in the part of the sacrificial layer region (14).

13. III-V semiconductor semi-finished production method according to any one of claims 8 to 12, **characterised in that** prior to the detaching of the semiconductor layer region (16) a carrier layer (22) is arranged on the upper side of the semiconductor layer region.

14. III-V semiconductor semi-finished production method according to any one of claims 8 to 13, **characterised in that** after the detaching the semiconductor layer region together with the surface freed from residues of the sacrificial layer region (14) is arranged on a carrier (24).

15. III-V semiconductor semi-finished production method according to any one of claims 8 to 14, **characterised in that** after the detaching the parts of the sacrificial layer region (14) remaining on the substrate (12) are removed and the substrate (12) is prepared for a new use.

16. III-V semiconductor semi-finished production method according to any one of claims 8 to 15, **characterised in that** the semiconductor layer region (14) is arranged on a carrier substrate by material couple.

## Revendications

1. Produit semi-fini pour semi-conducteur III-V à structure en pile (10) présentant un substrat (12),
une zone de couches sacrificielles (14) disposée sur le substrat (12) et
une zone de couches semi-conductrices (16) disposée sur une surface de la zone de couches sacrificielles (14), dans lequel
- le substrat (12), la zone de couches sacrificielles (14) et la zone de couches semi-conductrices (16) comprennent chacun au moins un élément chimique du groupe III et un élément chimique du groupe V,
- au moins une partie de la zone de couches sacrificielles (14) se distingue par au moins un élément du substrat (12) et de la partie de la zone de couches semi-conductrices (16) disposée immédiatement sur la surface de la zone de couches sacrificielles et
- la vitesse de gravure pour un processus de gravure prédéfini se distingue, au moins pour une partie de la zone de couches sacrificielles (14), par au moins un facteur 10 de la vitesse de gravure pour le substrat (12) et de la vitesse de gravure pour la partie de la zone de couches semi-conductrices (16) disposée immédiatement sur la surface de la zone de couches sacrificielles (14), **caractérisé en ce que**
- la zone de couches sacrificielles (14) comprend une couche au moins partiellement amorphisée (18) produite par implantation,
- la couche amorphisée (18) est disposée à proximité du milieu ou au milieu de la zone de couches sacrificielles (14) et
- la zone de couches sacrificielles (14) comprend exactement trois couches sacrificielles (14.2, 14.4, 14.-) et les deux couches extérieures (14.2, 14.6) contiennent de l'InGaAs ou de l'AlAs ou du GaInP ou de l'AlGaAs ou sont constituées d'InGaAs ou d'AlAs ou de GaInP ou d'AlGaAs et la couche sacrificielle centrale (14.4) contient du GaAs ou est constituée de GaAs.

2. Produit semi-fini pour semi-conducteur III-V à structure en pile (10) selon la revendication 1, **caractérisé en ce que** les vitesses de gravure se distinguent par au moins un facteur 100 ou au moins par un facteur 1000.

3. Produit semi-fini pour semi-conducteur III-V à structure en pile (10) selon la revendication 1 ou la revendication 2, **caractérisé en ce que** la zone de couches sacrificielles (14) comprend plusieurs couches sacrificielles disposées en empilement les unes sur les autres.

4. Produit semi-fini pour semi-conducteur III-V à structure en pile (10) selon une des revendications 1 à 3, **caractérisé en ce qu'**au moins une partie ou la totalité de la zone de couches sacrificielles (14) à l'exception de la couche amorphisée (18) est appariée en réseau au substrat (12) et à au moins une partie de la zone de couches semi-conductrices (16).

5. Produit semi-fini pour semi-conducteur III-V à structure en pile (10) selon une des revendications 1 à 4, **caractérisé en ce que** la zone de couches sacrificielles (14) présente une épaisseur de couche de 0,1 µm à 10 µm ou de 1 µm à 3 µm.

6. Produit semi-fini pour semi-conducteur III-V à structure en pile (10) selon une des revendications 1 à 5, **caractérisé en ce que** le substrat (12) est constitué de GaN ou de GaAs ou d'InP.

7. Produit semi-fini pour semi-conducteur III-V à structure en pile (10) selon une des revendications 1 à 6, **caractérisé en ce que** la zone de couches semi-conductrices (16) présente une épaisseur de couche de 0,3 µm à 30 µm ou de 1 µm à 5 µm.

8. Procédé de fabrication de produits semi-finis pour semi-conducteurs III-V (10) dans lequel
- un substrat (12) est réalisé et
- une zone de couches sacrificielles (14) appariée en réseau au substrat (12) est produite sur le substrat (12),
- dans lequel la zone de couches sacrificielles (14) produite comprend exactement trois couches sacrificielles (14.2, 14.4, 14.6) et les deux couches extérieures (14.2, 14.6) contiennent de l'InGaAs ou de l'AlAs ou du GaInP ou de l'AlGaAs ou sont constituées d'InGaAs ou d'AlAs ou de GaInP ou d'AlGaAs et la couche sacrificielle centrale (14.4) contient du GaAs ou est constituée de GaAs,
- une couche au moins partiellement amorphisée (18) est ensuite produite au moyen d'une implantation à l'intérieur de la zone de couches sacrificielles (14), à proximité du milieu ou au milieu de la zone de couches sacrificielles (14),
- une zone de couches semi-conductrices (16) est ensuite produite, le substrat, la zone de couches sacrificielles (14) et la zone de couches semi-conductrices (16) présentant chacun au moins un élément chimique du groupe III et un élément chimique du groupe V,
- le substrat (12) est détaché de la zone de couches semi-conductrices (16) le long de la zone de couches sacrificielles (14) et
- une partie de la zone de couches sacrificielles (14) restant sur le substrat (12) et la zone de couches semi-conductrices (16) est éliminée par un procédé de gravure, la vitesse de gravure pour au moins une partie de la zone de couches sacrificielles (14) se distinguant d'au moins un facteur 10 de la vitesse de gravure pour le substrat ainsi que de la vitesse de gravure pour la partie de la zone de couches semi-conductrices (16) disposée immédiatement sur la surface de la zone de couches sacrificielles.

9. Procédé de fabrication de produits semi-finis pour semi-conducteurs III-V selon la revendication 8, **caractérisé en ce qu'**au moins une partie ou la totalité de la zone de couches sacrificielles (14) à l'exception de la couche amorphisée (18) est appariée en réseau au substrat (12) et à au moins une partie de la zone de couches semi-conductrices (16).

10. Procédé de fabrication de produits semi-finis pour semi-conducteurs III-V selon une des revendications 8 ou 9, **caractérisée en ce que** la couche amorphisée (18) est produite en utilisant un faisceau de protons.

11. Procédé de fabrication de produits semi-finis pour semi-conducteurs III-V selon une des revendications 8 à 10, **caractérisée en ce que** l'implantation est effectuée avec une énergie de l'ordre de 20 keV à 500 keV et une dose de l'ordre de 1e14/cm² à 1e16/cm².

12. Procédé de fabrication de produits semi-finis pour semi-conducteurs III-V selon une des revendications 8 à 11, **caractérisée en ce que** le détachement est initié mécaniquement et effectué dans une partie de la zone de couches sacrificielles (14).

13. Procédé de fabrication de produits semi-finis pour semi-conducteurs III-V selon une des revendications 8 à 12, **caractérisée en ce qu'**avant le détachement de la zone de couches semi-conductrices (16), une couche de support (20) est disposée sur la face supérieure de la zone de couches semi-conductrices.

14. Procédé de fabrication de produits semi-finis pour semi-conducteurs III-V selon une des revendications 8 à 13, **caractérisée en ce qu'**après le détachement, la zone de couches semi-conductrices (16) est disposée avec la surface libérée des restes de la zone de couches sacrificielles (14) sur un support (24).

15. Procédé de fabrication de produits semi-finis pour semi-conducteurs III-V selon une des revendications 8 à 14, **caractérisée en ce qu'**après le détachement, les parties de la zone de couches sacrificielles (14) restant sur le substrat (12) sont éliminées et le substrat (12) est préparé pour une nouvelle utilisation.

16. Procédé de fabrication de produits semi-finis pour semi-conducteurs III-V selon une des revendications 8 à 15, **caractérisée en ce que** la zone de couches semi-conductrices (14) est disposée par adhérence sur un substrat de support.
